# EUROPEAN PATENT APPLICATION

(11) **EP 4 535 638 A1**
(43) Date of publication of application: **09.04.2025**
(21) Application number: 22944831.1
(22) Date of filing: 31.05.2022
(51) Int. Cl.: H02M 7/48

(54) **POWER CONVERSION DEVICE**

(71) Applicant: MITSUBISHI ELECTRIC CORPORATION, Chiyoda-ku Tokyo 100-8310 (JP)
(72) Inventor: SASAHARA, Ryoko, Tokyo 100-8310 (JP); YOSHIMURA, Manabu, Tokyo 100-8310 (JP)
(74) Representative: Meissner Bolte Partnerschaft mbB
(86) International application number: PCT/JP2022/022197
(87) International publication number: WO 2023/233544

(57) **Abstract**

A power converter of the present disclosure includes at least one insulating structure (20) and a plurality of power conversion units (10). The at least one insulating structure includes a plurality of stacked structures (30) stacked along a first direction (DR1). Each of the plurality of stacked structures includes a first bottom wall (31), a first upper wall (32), a first side wall (33), a second side wall (34), and a first back wall (35). The first bottom wall and the first upper wall face each other with a space therebetween in the first direction. The first side wall and the second side wall face each other with a space therebetween in a second direction (DR2) orthogonal to the first direction. An upper end and a lower end of the first side wall are connected to one end of the first bottom wall and one end of the first upper wall in the first direction, respectively. An upper end and a lower end of the second side wall are connected to the other end of the first bottom wall and the other end of the first upper wall in the first direction, respectively.

## Description

### TECHNICAL FIELD

The present disclosure relates to a power converter.

### BACKGROUND ART

For example, Japanese Patent No. 6995259 (PTL 1) describes a power converter. The power converter described in PTL 1 includes a plurality of submodules and an insulating structure. The plurality of submodules are arranged in a grid pattern along a first direction and a second direction. The first direction represents a horizontal direction, and the second direction represents a vertical direction. Two submodules adjacent to each other in the first direction and two submodules adjacent to each other in the second direction are insulated by the insulating structure.

### CITATION LIST

### PATENT LITERATURE

PTL 1: Japanese Patent No. 6995259

### SUMMARY OF INVENTION

### TECHNICAL PROBLEM

However, in the power converter described in PTL 1, there is room for improvement in suppressing the occurrence of electric discharge. The present disclosure has been made in view of the above-described problem of the related art. More specifically, the present disclosure provides a power converter capable of suppressing the occurrence of electric discharge.

### SOLUTION TO PROBLEM

The power converter of the present disclosure includes at least one insulating structure and a plurality of power conversion units. The at least one insulating structure includes a plurality of stacked structures stacked along a first direction. Each of the plurality of stacked structures has a first bottom wall, a first upper wall, a first side wall, a second side wall, and a first back wall. The first bottom wall and the first upper wall face each other with a space therebetween in the first direction. The first side wall and the second side wall face each other with a space therebetween in a second direction orthogonal to the first direction. An upper end and a lower end of the first side wall are connected to one end of the first bottom wall and one end of the first upper wall in the first direction, respectively. An upper end and a lower end of the second side wall are connected to the other end of the first bottom wall and the other end of the first upper wall in the first direction, respectively. The first back wall is connected to one end of the first bottom wall, one end of the first side wall, and one end of the second side wall in a third direction orthogonal to the first direction and the second direction. The first side wall and the second side wall are divided into a plurality of portions arranged with a space therebetween in the third direction. The plurality of power conversion units are arranged in the first direction with a space therebetween in each of the plurality of stacked structures. Each of the plurality of power conversion units has a bottom surface, an upper surface, a first side surface, a second side surface, and a back surface. The bottom surface is in contact with the first bottom wall. The upper surface is separated from the first upper wall. The first side surface and the second side surface face one side in the second direction and the other side in the second direction, respectively. The back surface faces one side in the third direction. In a first power conversion unit of the plurality of power conversion units that is adjacent to the first side wall, a corner portion between the first side surface and the back surface is covered by a corner portion between the first side wall and the first back wall. In a second power conversion unit of the plurality of power conversion units that is adjacent to the second side wall, a corner portion between the second side surface and the back surface is covered by a corner portion between the second side wall and the first back wall.

### ADVANTAGEOUS EFFECTS OF INVENTION

According to the power converter of the present disclosure, it is possible to suppress the occurrence of electric discharge.

### BRIEF DESCRIPTION OF DRAWINGS

Fig. 1 is a schematic circuit diagram of a power converter 100;
Fig. 2 is a schematic circuit diagram of the power conversion unit 10;
Fig. 3 is a front view of the power converter 100;
Fig. 4 is a rear view of the power converter 100;
Fig. 5 is a first side view of the power converter 100;
Fig. 6 is a second side view of the power converter 100;
Fig. 7 is a cross-sectional view taken along line VII-VII in Fig. 3;
Fig. 8 is a perspective view of the power converter 100;
Fig. 9 is a front view of an insulating case 40;
Fig. 10 is a rear view of the insulating case 40;
Fig. 11 is a first side view of the insulating case 40;
Fig. 12 is a second side view of the insulating case 40;
Fig. 13 is a perspective view of the insulating case 40;
Fig. 14 is a perspective view of the power converter 100 having a plurality of insulating structures 20;
Fig. 15 is a first side view of the power converter 100 having a plurality of insulating structures 20;
Fig. 16 is a second side view of the power converter 100 having a plurality of insulating structures 20;
Fig. 17 is a perspective view of an insulating case 40 in a power converter 100A;
Fig. 18 is a graph illustrating an intensity of an electric field at a ridge line between a bottom surface 10a and a side surface 10c;
Fig. 19 is a perspective view of a power converter 200;
Fig. 20 is a side view of the power converter 200;
Fig. 21 is a perspective view of a power converter 300;
Fig. 22 is a rear view of an insulating structure 20 in the power converter 300;
Fig. 23 is a perspective view of a power converter 400;
Fig. 24 is a front view of a power converter 500;
Fig. 25 is a plan view of the power converter 500;
Fig. 26 is an exploded perspective view of the power converter 500;
Fig. 27A is a perspective view illustrating the position of a maximum electric field portion in a conductive member 70 when a shield member 71 is provided;
Fig. 27B is a perspective view illustrating the position of a maximum electric field portion in a conductive member 70 when a shield member 71 is not provided;
Fig. 28 is a perspective view of a power converter 600;
Fig. 29 is a plan view of the power converter 600; and
Fig. 30 is a plan view of the power converter 600 according to a modification.

### DESCRIPTION OF EMBODIMENTS

Embodiments of the present disclosure will be described in detail with reference to the drawings. In the following drawings, the same or corresponding parts are denoted by the same reference numerals, and the description will not be repeated.

### First Embodiment

A power converter according to a first embodiment will be described. The power converter according to the first embodiment is referred to as a power converter 100.

### (Configuration of Power Converter 100)

Hereinafter, the configuration of the power converter 100 will be described.

The power converter 100 is, for example, a MMC (Multilevel Modular Convertor)-type HVDC (High Voltage DC) converter. However, the power converter 100 is not limited thereto.

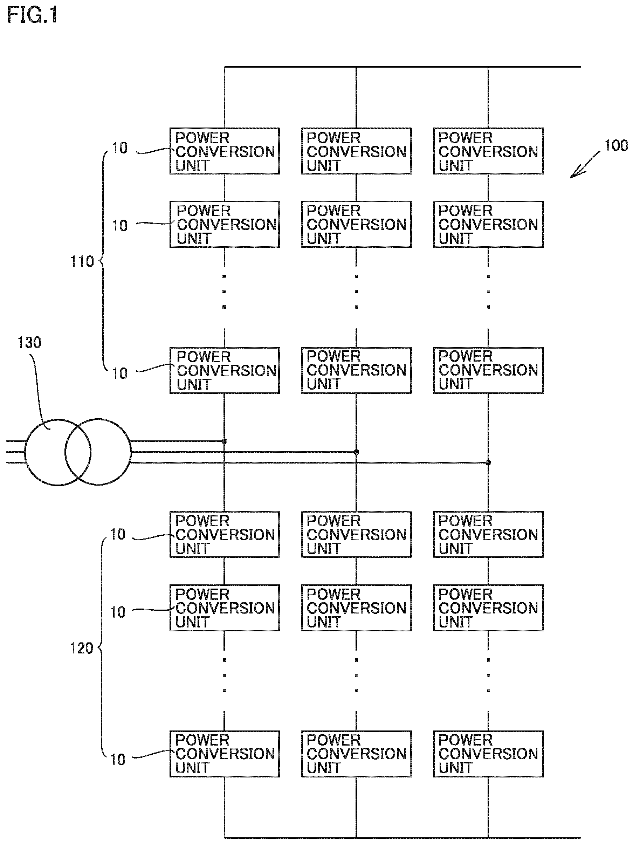

Fig. 1 is a schematic circuit diagram of the power converter 100. As illustrated in Fig. 1, the power converter 100 includes multiple pairs of an upper arm 110 and a lower arm 120. The upper arm 110 and the lower arm 120 are connected to each other in series. The multiple pairs of the upper arm 110 and the lower arm 120 are connected to each other in parallel. A transformer 130 is connected between the upper arm 110 and the lower arm 120. The upper arm 110 and the lower arm 120 each include a plurality of power conversion units 10 connected to each other in series.

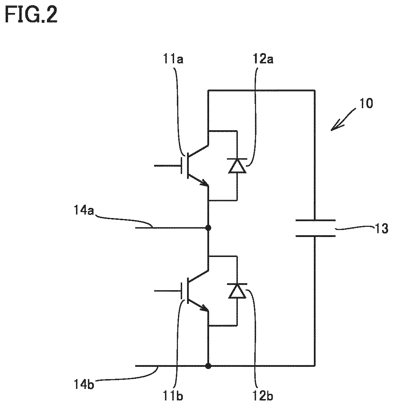

Fig. 2 is a schematic circuit diagram of the power conversion unit 10. As illustrated in Fig. 2, the power conversion unit 10 includes, for example, a switching element 11a and a switching element 11b, a diode 12a and a diode 12b, a capacitor 13, and a connection line 14a and a connection line 14b.

Each of the switching element 11a and the switching element 11b is, for example, an IGBT (Insulated Gate Bipolar Transistor). The switching element 11a and the switching element 11b are connected to each other in series.

The diode 12a is connected in parallel to the switching element 11a in a reverse bias manner, and the diode 12b is connected in parallel to the switching element 11b in a reverse bias manner. The capacitor 13 is connected in parallel to the switching element 11a and the switching element 11b which are connected to each other in series.

The connection line 14a is connected to an emitter of the switching element 11a and a collector of the switching element 11b. The connection line 14b is connected to an emitter of the switching element 11b. The connection line 14a of one power conversion unit 10 is connected to the connection line 14b of another adjacent power conversion unit 10. Thus, the power conversion unit 10 constitutes a half-bridge converter cell. The power conversion unit 10 may constitute a full-bridge converter cell.

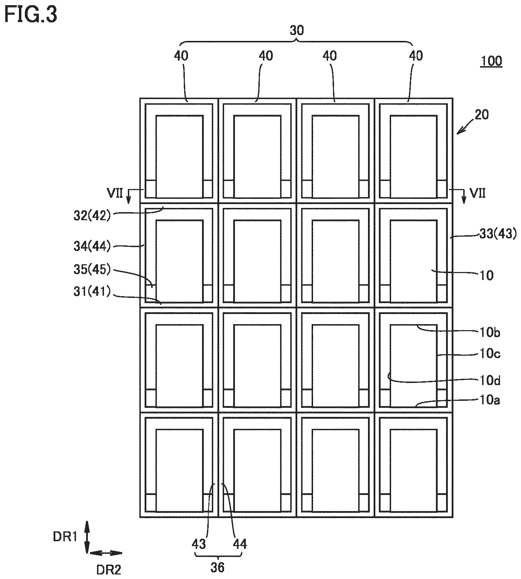

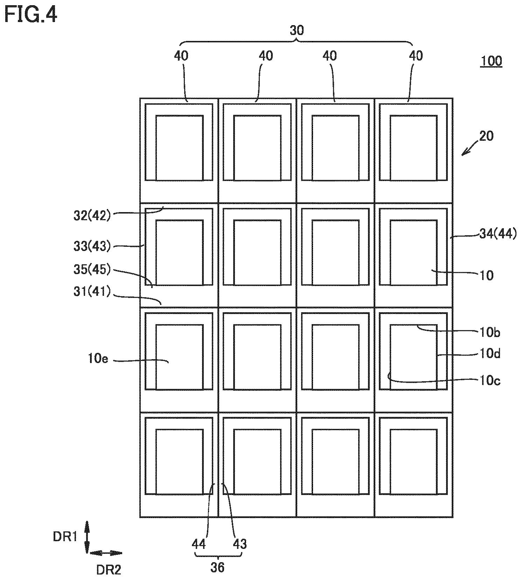

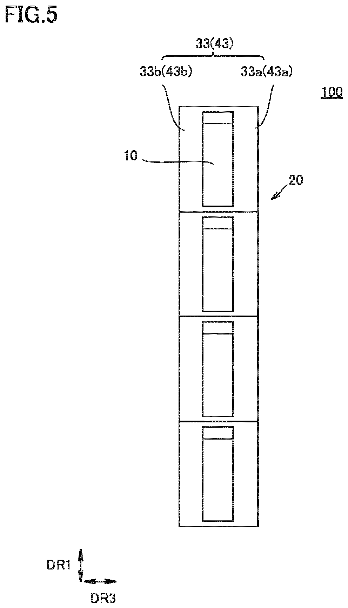

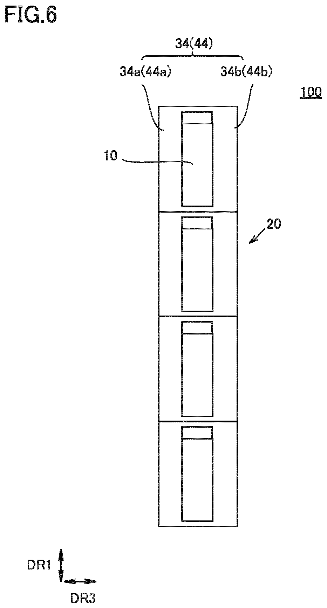

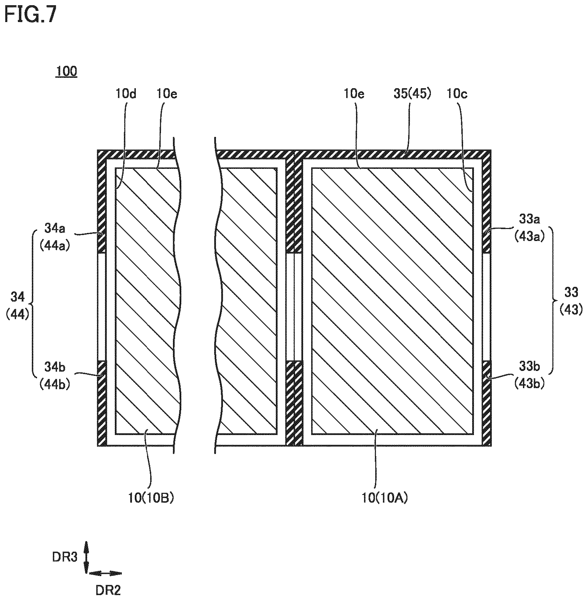

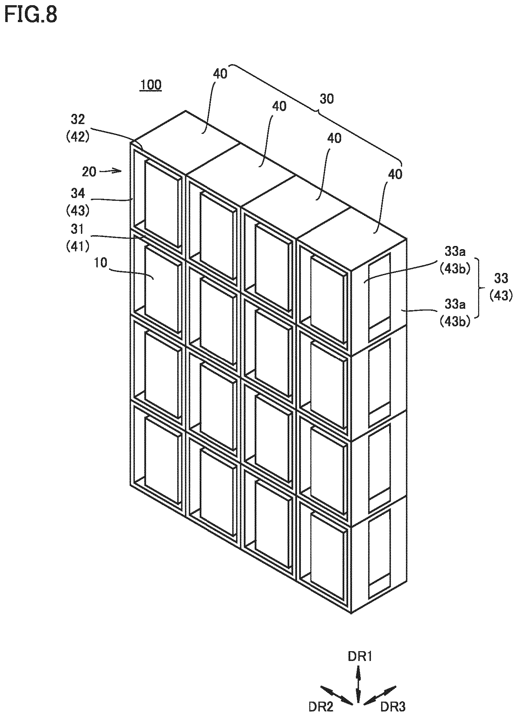

Fig. 3 is a front view of the power converter 100. Fig. 4 is a rear view of the power converter 100. Fig. 5 is a first side view of the power converter 100. Fig. 6 is a second side view of the power converter 100. Fig. 7 is a cross-sectional view taken along line VII-VII in Fig. 3. Fig. 8 is a perspective view of the power converter 100. As illustrated in Figs. 3 to 8, the power converter 100 includes an insulating structure 20.

The insulating structure 20 is formed of an electrically insulating material. The insulating structure 20 is formed of, for example, FRP (Fiber Reinforced Plastic), glass epoxy resin, cast epoxy resin, polyethylene, vinyl chloride, silicone, fluorine synthetic rubber, nylon, electrically insulating ceramics, or the like. The insulating structure 20 includes a plurality of stacked structures 30.

The plurality of stacked structures 30 are stacked in a first direction DR1. The first direction DR1 corresponds to, for example, the vertical direction. The stacked structure 30 includes a bottom wall 31, an upper wall 32, a side wall 33, a side wall 34, a back wall 35, and a plurality of partition walls 36. The upper wall 32 of one stacked structure 30 is connected to the bottom wall 31 of another stacked structure 30 adjacent to the one stacked structure 30 by an adhesive, a bolt, or the like.

The bottom wall 31 and the upper wall 32 face each other with a space therebetween in the first direction DR1. The side wall 33 and the side wall 34 face each other with a space therebetween in a second direction DR2. The second direction DR2 is orthogonal to the first direction DR1. The second direction DR2 corresponds to, for example, the horizontal direction. A lower end and an upper end of the side wall 33 are connected to one end (the right end in Fig. 3) of the bottom wall 31 and one end of the upper wall 32 in the second direction DR2, respectively. A lower end and an upper end of the side wall 34 are connected to the other end (the left end in Fig. 3) of the bottom wall 31 and the other end of the upper wall 32 in the second direction DR2, respectively.

A third direction DR3 is orthogonal to the first direction DR1 and the second direction DR2, and corresponds to, for example, the horizontal direction. The back wall 35 is connected to one end (the right end in Fig. 5) of the bottom wall 31, one end of the side wall 33, and one end of the side wall 34 in the third direction DR3. However, the back wall 35 is not connected to one end of the upper wall 32 in the third direction DR3, whereby an opening is formed between the back wall 35 and the upper wall 32. The plurality of partition walls 36 are arranged between the side wall 33 and the side wall 34 in the second direction DR2. A lower end and an upper end of the partition wall 36 are connected to the bottom wall 31 and the upper wall 32, respectively. One end of the partition wall 36 in the third direction DR3 is connected to the back wall 35.

The power conversion unit 10 is disposed in a space defined by the bottom wall 31, the upper wall 32, the side wall 33, the back wall 35 and the partition wall 36, a space defined by the bottom wall 31, the upper wall 32, the side wall 34, the back wall 35 and the partition wall 36, and a space defined by the bottom wall 31, the upper wall 32, the back wall 35 and two adjacent partition walls 36, respectively. In other words, a plurality of power conversion units 10 are arranged in the second direction DR2 inside the stacked structure 30. Two of the power conversion units 10 that are adjacent to each other in the second direction DR2 are electrically connected to each other. One power conversion unit 10 (a power conversion unit 10A or a power conversion unit 10B to be described later) at one side or the other side of the second direction DR2 may be also electrically connected to a power conversion unit 10 other than the adjacent power conversion unit 10 in the second direction DR2.

The side wall 33 is divided into a plurality of portions in the third direction DR3. The side wall 33 has a first portion 33a and a second portion 33b, for example. The first portion 33a and the second portion 33b are located at one end and the other end of the side wall 33 in the third direction DR3, respectively. The first portion 33a and the second portion 33b are separated from each other in the third direction DR3. In other words, the side wall 33 is open between the first portion 33a and the second portion 33b.

The side wall 34 is divided into a plurality of portions in the third direction DR3. The side wall 34 has a first portion 34a and a second portion 34b, for example. The first portion 34a and the second portion 34b are located at one end and the other end of the side wall 34 in the third direction DR3, respectively. The first portion 34a and the second portion 34b are separated from each other in the third direction DR3. In other words, the side wall 34 is open between the first portion 34a and the second portion 34b.

The partition wall 36 is divided into a plurality of portions in the third direction DR3. The partition wall 36 has a first portion 36a and a second portion 36b, for example. The first portion 36a and the second portion 36b are located at one end and the other end of the partition wall 36 in the third direction DR3, respectively. The first portion 36a and the second portion 36b are separated from each other in the third direction DR3. In other words, the partition wall 36 is open between the first portion 36a and the second portion 36b.

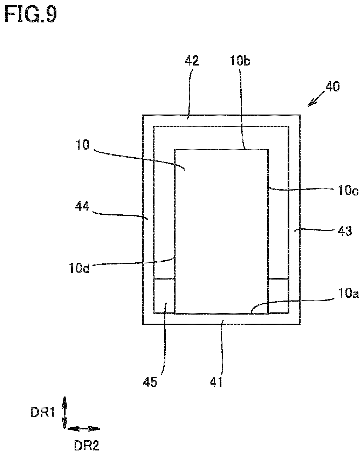

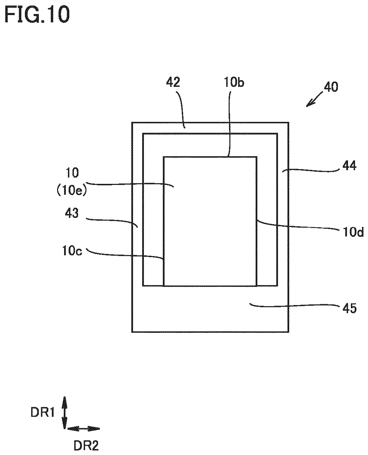

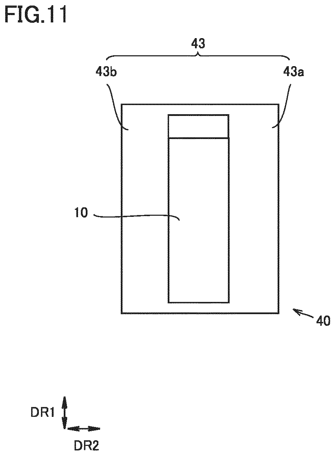

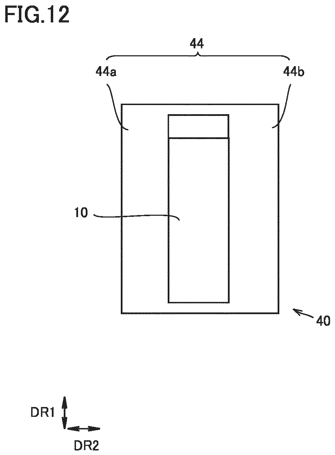

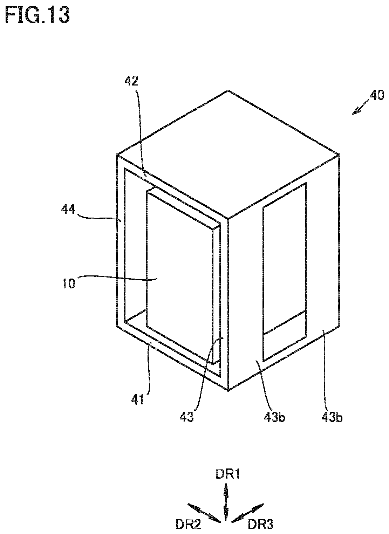

The stacked structure 30 includes a plurality of insulating cases 40. The plurality of insulating cases 40 are arranged along the second direction DR2. Fig. 9 is a front view of the insulating case 40. Fig. 10 is a rear view of the insulating case 40. Fig. 11 is a first side view of the insulating case 40. Fig. 12 is a second side view of the insulating case 40. Fig. 13 is a perspective view of the insulating case 40. As illustrated in Figs. 10 to 13, the insulating case 40 has a bottom wall 41, an upper wall 42, a side wall 43, a side wall 44, and a back wall 45.

The bottom wall 41 and the upper wall 42 face each other with a space therebetween in the first direction DR1. The side wall 43 and the side wall 44 face each other with a space therebetween in the second direction DR2. A lower end and an upper end of the side wall 43 are connected to one end of the bottom wall 41 and one end of the upper wall 42 in the second direction DR2, respectively. A lower end and an upper end of the side wall 44 are connected to the other end of the bottom wall 41 and the other end of the upper wall 42 in the second direction DR2, respectively. The back wall 45 is connected to one end of the bottom wall 41, one end of the side wall 43, and one end of the side wall 44 in the third direction DR3. The back wall 45 is not connected to one end of the upper wall 42 in the third direction DR3, whereby an opening is formed between the back wall 45 and the upper wall 42.

The side wall 43 is divided into a plurality of portions in the third direction DR3. The side wall 43 has a first portion 43a and a second portion 43b, for example. The first portion 43a and the second portion 43b are located at one end and the other end of the side wall 43 in the third direction DR3, respectively. The side wall 43 is divided into a plurality of portions in the third direction DR3. The side wall 44 has a first portion 44a and a second portion 44b, for example. The first portion 44a and the second portion 44b are located at one end and the other end of the side wall 44 in the third direction DR3, respectively.

The side wall 43 of one insulating case 40 is connected to the side wall 44 of another insulating case 40 adjacent to the one insulating case 40 by an adhesive, a bolt, or the like. The bottom wall 41 constitutes a part of the bottom wall 31, and the upper wall 42 constitutes a part of the upper wall 32. The side wall 43 at one end in the second direction DR2 constitutes the side wall 33, and the side wall 44 at the other end in the second direction DR2 constitutes the side wall 34. The side wall 43 and the side wall 44 adjacent to each other constitute the partition wall 36. The power conversion unit 10 is disposed in the insulating case 40.

The power conversion unit 10 has a bottom surface 10a and an upper surface 10b. The power conversion unit 10 also has a side surface 10c, a side surface 10d, and a back surface 10e. The bottom surface 10a, the upper surface 10b, the side surface 10c, the side surface 10d, and the back surface 10e are surfaces of a case of the power conversion unit 10. The case is made of metal, for example. The bottom surface 10a is in contact with the bottom wall 31 (the bottom wall 41). The upper surface 10b is spaced apart from the upper wall 32 (the upper wall 42). The side surface 10c and the side surface 10d face one side and the other side of the second direction DR2, respectively. The back surface 10e faces one side of the third direction DR3.

Among the plurality of power conversion units 10 disposed inside the stacked structure 30, a power conversion unit that is adjacent to the side wall 33 is referred to as a power conversion unit 10A. Among the plurality of power conversion units 10 disposed inside the stacked structure 30, a power conversion unit that is adjacent to the side wall 34 is referred to as a power conversion unit 10B.

In the power conversion unit 10A, a corner portion (a first corner portion) between the side surface 10c and the back surface 10e is covered by a corner portion (a second corner portion) between the side wall 33 and the back wall 35. In the power conversion unit 10B, a corner portion (a third corner portion) between the side surface 10d and the back surface 10e is covered by a corner portion (a fourth corner portion) between the side wall 34 and the back wall 35. Preferably, in the power conversion unit 10A, the side surface 10c is separated from the side wall 33 in the second direction DR2, and the back surface 10e is separated from the back wall 35 in the third direction DR3. Preferably, in the power conversion unit 10B, the side surface 10d is separated from the side wall 34 in the second direction DR2, and the back surface 10e is separated from the back wall 35 in the third direction DR3.

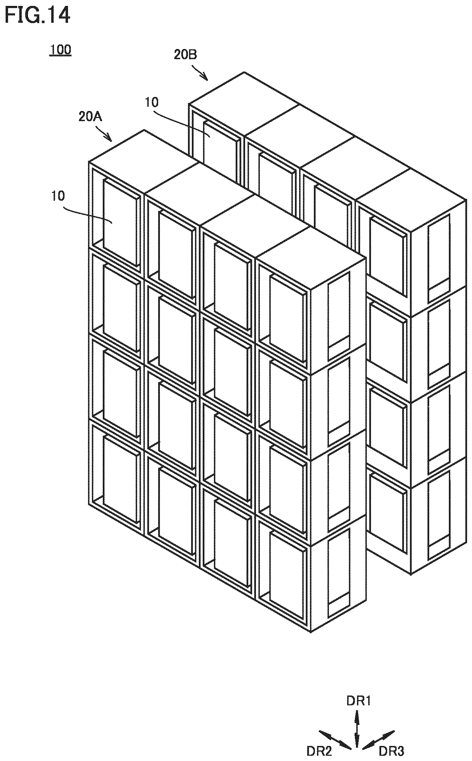

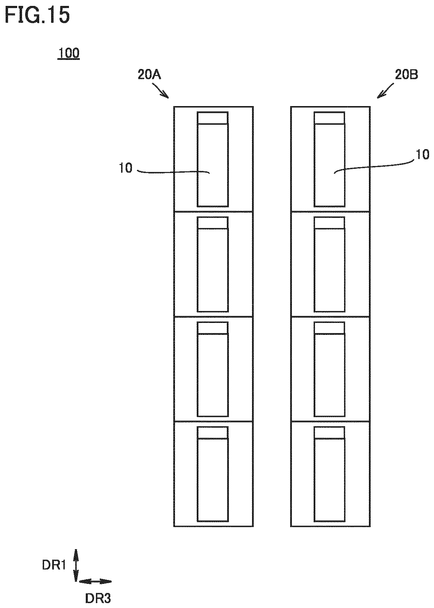

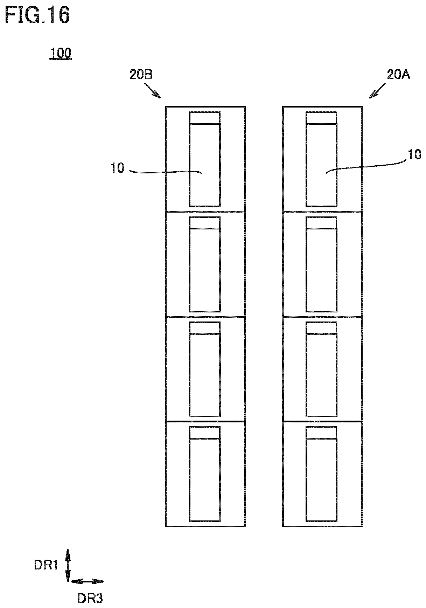

Fig. 14 is a perspective view of the power converter 100 having a plurality of insulating structures 20. Fig. 15 is a first side view of the power converter 100 having a plurality of insulating structures 20. Fig. 16 is a second side view of the power converter 100 having a plurality of insulating structures 20. As illustrated in Figs. 14 to 16, the power converter 100 may have a plurality of insulating structures 20. In the example illustrated in Figs. 14 to 16, the power converter 100 has two insulating structures 20. The two insulating structures 20 are referred to as an insulating structure 20A and an insulating structure 20B. The insulating structure 20A and the insulating structure 20B are arranged in a back-to-back manner with a space therebetween. In other words, the insulating structure 20A and the insulating structure 20B are arranged in such a manner that the back walls 35 face each other with a space therebetween.

In the examples illustrated in Figs. 14 to 16, a potential difference between two power conversion units 10 adjacent to each other in the second direction DR2 is the smallest, and a potential difference between two power conversion units 10 adjacent to each other in the third direction DR3 is the largest. In the examples illustrated in Figs. 14 to 16, the insulating structure 20A and the insulating structure 20B are arranged in a back-to-back manner with a space therebetween, and if the potential difference between two adjacent power conversion units 10 in the third direction DR3 is small, the insulating structure 20A and the insulating structure 20B may be disposed in a back-to-back manner without a space therebetween.

### (Effects of Power Converter 100)

The effects of the power converter 100 will be described below.

As described above, the upper surface 10b is separated from the upper wall 32, while the bottom surface 10a is in contact with the bottom wall 31. Therefore, a portion where the bottom surface 10a and the bottom wall 31 are in contact with each other becomes a triple junction of air, metal and insulator, which may likely become a starting point of electric discharge due to the occurrence of electric field concentration. If the back wall 35 is extended to reach one end of the upper wall 32 in the third direction DR3, the withstand voltage performance is improved due to barrier insulation. However, if an insulator having a dielectric constant higher than that of air is present in the vicinity of the electric field concentration portion, the electric field at the electric field concentration portion will be stronger than that in the absence of such an insulator.

In the power converter 100, since the space between the upper wall 32 and the back wall 35 is open, an insulator is present only in the vicinity of the electrolytic concentration portion, and no insulator is present in the portion that is unlikely to become a starting point of electric discharge. As a result, according to the power converter 100, the electric field concentration in the vicinity of the electric field concentration portion is mitigated, whereby the electric discharge is less likely to occur.

Since the back surface 10e is facing another power conversion unit 10 having the largest potential difference, the first corner portion and the third corner portion are likely to become starting points of electric discharge due to the occurrence of electric field concentration. In the power converter 100, since the first corner portion and the third corner portion are covered by the second corner portion and the fourth corner portion, respectively, and the side wall 33 and the side wall 34 are divided into a plurality of portions, the insulator is present only in the vicinity of the electric field concentration portion and is not present in a portion that is unlikely to become a starting point of electric discharge. Therefore, according to the power converter 100, the electric field concentration in the vicinity of the electric field concentration portion is mitigated, whereby the electric discharge is less likely to occur.

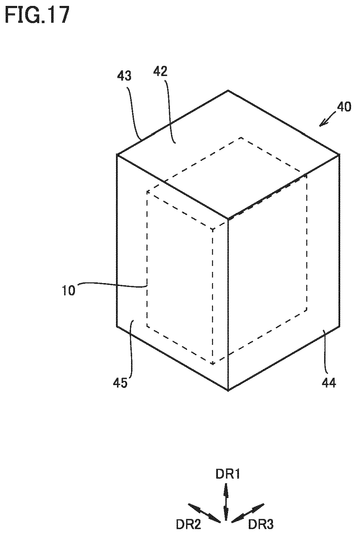

A power converter according to a comparative example is referred to as a power converter 100A. The configuration of the power converter 100A is the same as the configuration of the power converter 100 except for the insulating case 40. Fig. 17 is a perspective view of the insulating case 40 in the power converter 100A. As illustrated in Fig. 17, in the insulating case 40 of the power converter 100A, the side wall 43 and the side wall 44 are not divided into a plurality of portions. Moreover, in the insulating case 40 of the power converter 100A, the back wall 45 extends to reach one end of the upper wall 42 in the third direction DR3.

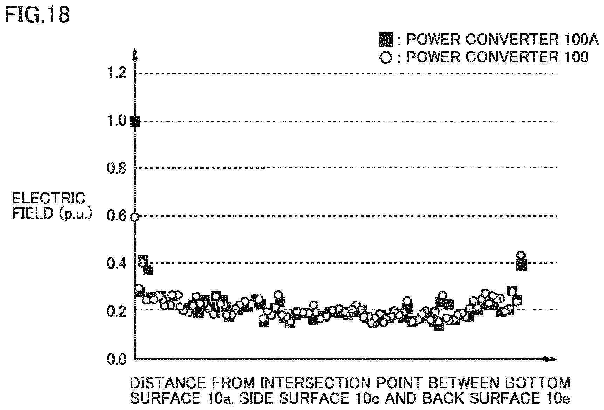

Fig. 18 is a graph illustrating an intensity of an electric field at a ridge line between the bottom surface 10a and the side surface 10c. The vertical axis in Fig. 18 indicates a strength of an electric field at the ridge line between the bottom surface 10a and the side surface 10c. The horizontal axis in Fig. 18 indicates a distance from an intersection point between the bottom surface 10a, the side surface 10c and the back surface 10e. As illustrated in Fig. 18, in the power converter 100 and the power converter 100A, the intersection point between the bottom surface 10a, the side surface 10c and the back surface 10e is an electric field concentration point. However, in the power converter 100, the strength of the electric field at the electric field concentration portion is mitigated as compared with the power converter 100. As described above, in the power converter 100, the electric field concentration in the vicinity of the electric field concentration portion is mitigated, whereby the electric discharge is less likely to occur.

### Second Embodiment

A power converter according to a second embodiment will be described. The power converter according to the second embodiment is referred to as a power converter 200. In the present embodiment, the differences from the power converter 100 will be mainly described, and the description of the same components will not be repeated.

### (Configuration of Power Converter 200)

Hereinafter, the configuration of the power converter 200 will be described.

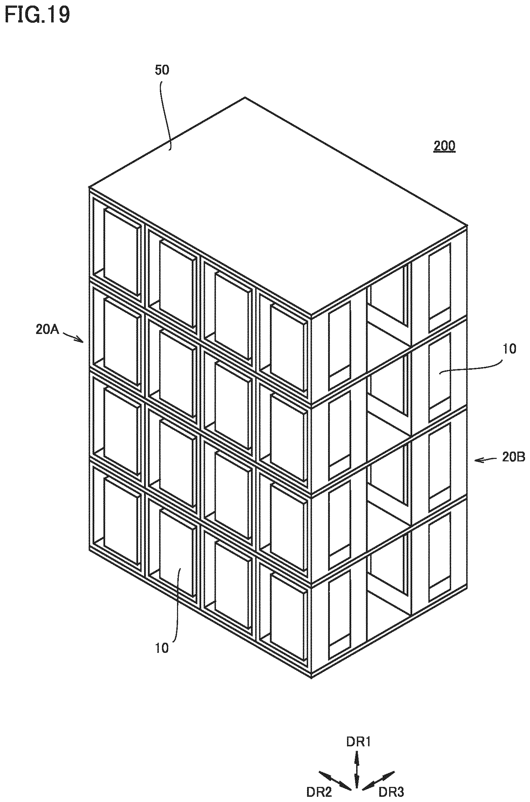

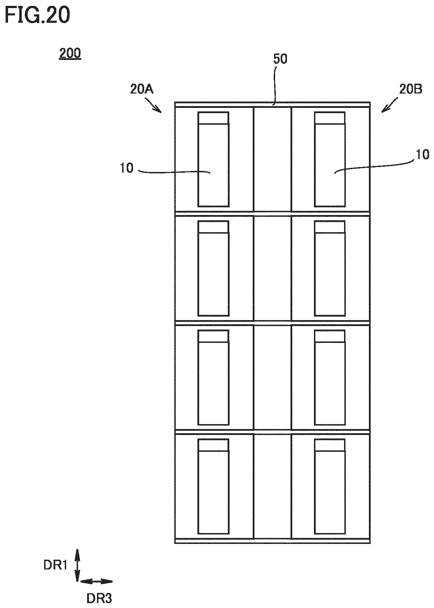

Fig. 19 is a perspective view of the power converter 200. Fig. 20 is a side view of the power converter 200. As illustrated in Figs. 19 and 20, the power converter 200 includes a plurality of power conversion units 10 and a plurality of insulating structures 20 (insulating structures 20A and 20B). In this regard, the configuration of the power converter 200 is the same as the configuration of the power converter 100.

The power converter 200 further includes a plurality of insulating connection members 50. The insulating connection member 50 is formed of an electrically insulating material. The insulating connection member 50 connects the insulating structure 20A and the insulating structure 20B. More specifically, the insulating connection member 50 connects each of the plurality of stacked structures 30 constituting the insulating structure 20A and each of the plurality of stacked structures 30 constituting the insulating structure 20B. A part of the plurality of stacked structures 30 constituting the insulating structure 20A may not be connected to a part of the plurality of stacked structures 30 constituting the insulating structure 20B by the insulating connection member 50. In these regards, the configuration of the power converter 200 is different from the configuration of the power converter 100.

### (Effects of Power Converter 200)

The effects of the power converter 200 will be described below.

In the power converter 200, since the insulating structure 20A and the insulating structure 20B are connected by the insulating connection member 50, the distance between the insulating structure 20A and the insulating structure 20B is mechanically kept constant. Therefore, even if a vibration such as an earthquake or the like is applied to the power converter, the insulation distance between the insulating structure 20A and the insulating structure 20B is prevented from becoming smaller than expected.

### Third Embodiment

A power converter according to a third embodiment will be described. The power converter according to the third embodiment is referred to as a power converter 200. In the present embodiment, the differences from the power converter 200 will be mainly described, and the description of the same components will not be repeated.

### (Configuration of Power Converter 300)

Hereinafter, the configuration of the power converter 300 will be described.

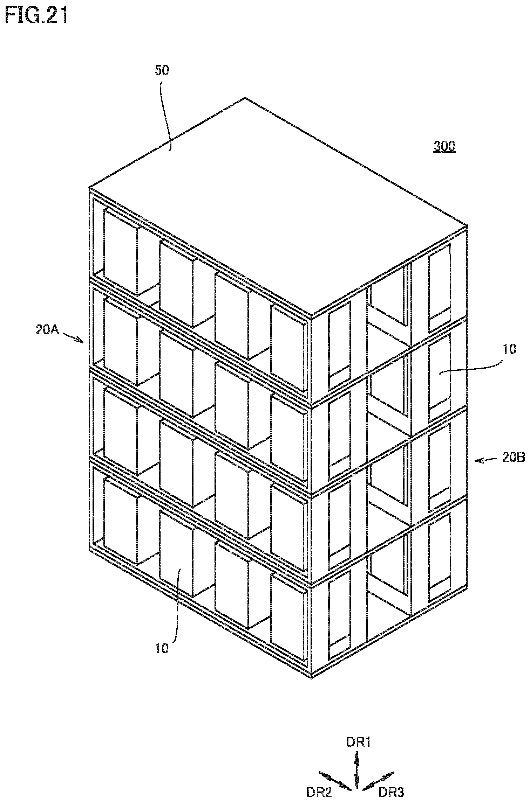

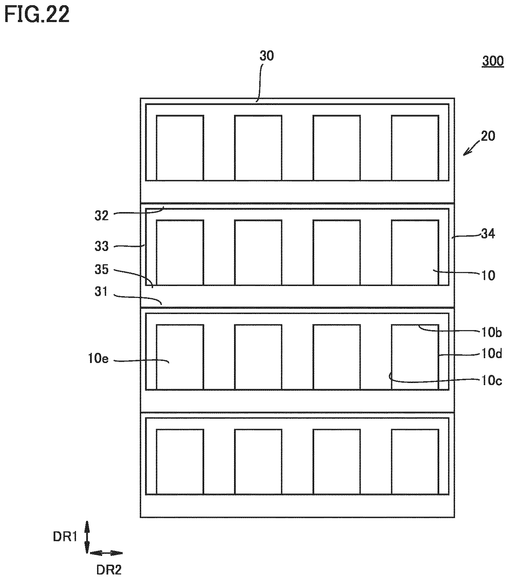

Fig. 21 is a perspective view of the power converter 300. Fig. 22 is a rear view of the insulating structure 20 in the power converter 300. As illustrated in Figs. 21 and 22, the power converter 300 includes a plurality of power conversion units 10, a plurality of insulating structures 20 (insulating structures 20A and 20B), and a plurality of insulating connection members 50. In this regard, the configuration of the power converter 300 is the same as the configuration of the power converter 200.

In the power converter 300, the stacked structure 30 includes a bottom wall 31, an upper wall 32, a side wall 33, a side wall 34, and a back wall 35, but does not include a partition wall 36 and is not constituted by the plurality of insulating cases 40. In this regard, the configuration of the power converter 300 is different from the configuration of the power converter 200. In the example illustrated in Figs. 21 and 22, the stacked structure 30 does not include a partition wall 36, but the partition wall 36 may be disposed in a portion between two power conversion units 10 adjacent to each other in the second direction DR2.

### (Effects of Power Converter 300)

The effects of the power converter 300 will be described below.

The potential difference between the two adjacent power conversion units 10 is the smallest in the second direction DR2 between the two adjacent power conversion units 10. When the potential difference between the two adjacent power conversion units 10 in the second direction DR2 is small, even if the partition wall 36 is not disposed, it is possible to suppress the dielectric breakdown between the two adjacent power conversion units 10 in the second direction DR2. Therefore, in the power converter 300, it is possible to suppress the dielectric breakdown between two power conversion units 10 adjacent to each other in the second direction DR2 while reducing the weight of the stacked structure 30.

### Fourth Embodiment

A power converter according to a fourth embodiment will be described. The power converter according to the fourth embodiment is referred to as a power converter 400. In the present embodiment, the differences from the power converter 100 will be mainly described, and the description of the same components will not be repeated.

### (Configuration of Power Converter 400)

Hereinafter, the configuration of the power converter 400 will be described.

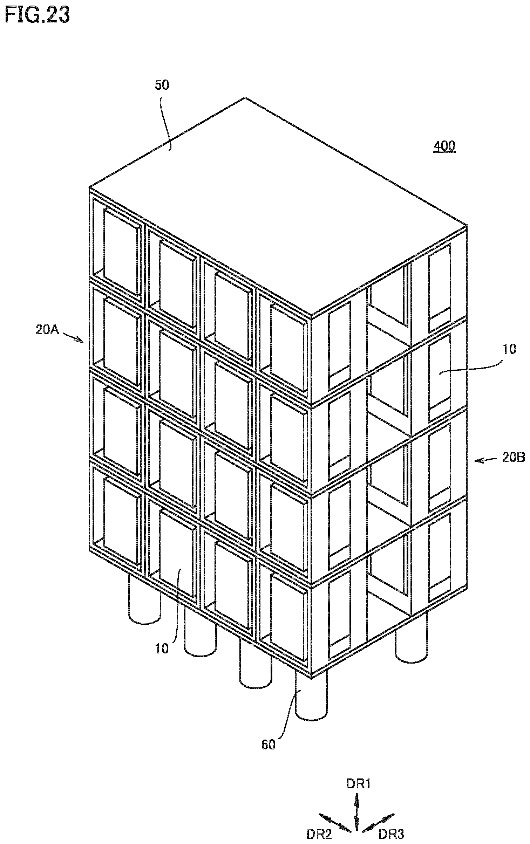

Fig. 23 is a perspective view of the power converter 400. As illustrated in Fig. 23, the power converter 400 includes a plurality of power conversion units 10 and a plurality of insulating structures 20 (insulating structures 20A and 20B). In this regard, the configuration of the power converter 400 is the same as the configuration of the power converter 100.

The power converter 400 further includes a plurality of insulating posts 60. The insulating post 60 is formed of an electrically insulating material. The insulating post 60 is formed of, for example, FRP, glass epoxy resin, the other epoxy resin, polyethylene, vinyl chloride, silicone, fluorine synthetic rubber, nylon, polymer insulator, ceramic insulator, or the like. The insulating post 60 extends in the first direction DR1. The plurality of insulating posts 60 are arranged, for example, in a grid pattern in a plan view. The insulating structure 20A and the insulating structure 20B are disposed on the plurality of insulating posts 60. In these regards, the configuration of the power converter 400 is different from the configuration of the power converter 100.

### (Effects of Power Converter 400)

Hereinafter, the effects of the power converter 400 will be described.

When a surge voltage is applied due to a failure during operation, an operation of a peripheral device, a lightning strike or the like, an electric discharge may occur from the power conversion unit 10 toward a ground object. In the power converter 400, since the insulating structure 20A and the insulating structure 20B are supported by the plurality of insulation posts 60 to secure the distance between the power conversion unit 10 and the ground, it is possible to suppress the occurrence of an electric discharge as described above.

### Fifth Embodiment

A power converter according to a fifth embodiment will be described. The power converter according to the fifth embodiment is referred to as a power converter 500. In the present embodiment, the differences from the power converter 400 will be mainly described, and the description of the same components will not be repeated.

### (Configuration of Power Converter 500)

Hereinafter, the configuration of the power converter 500 will be described.

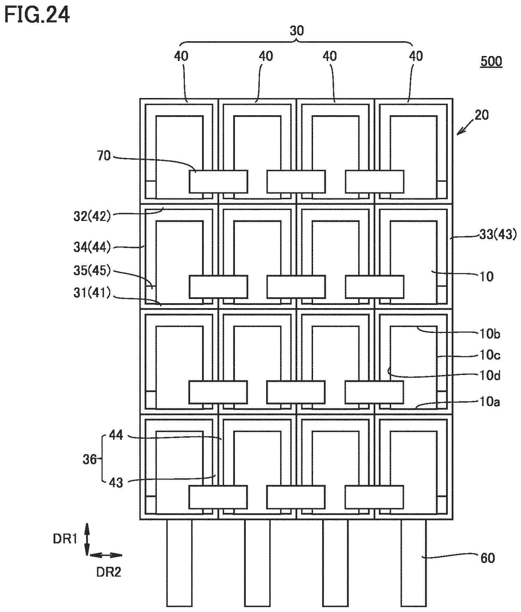

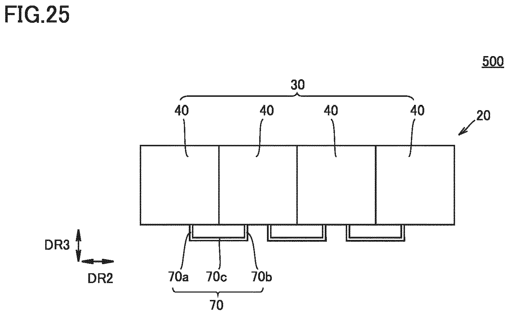

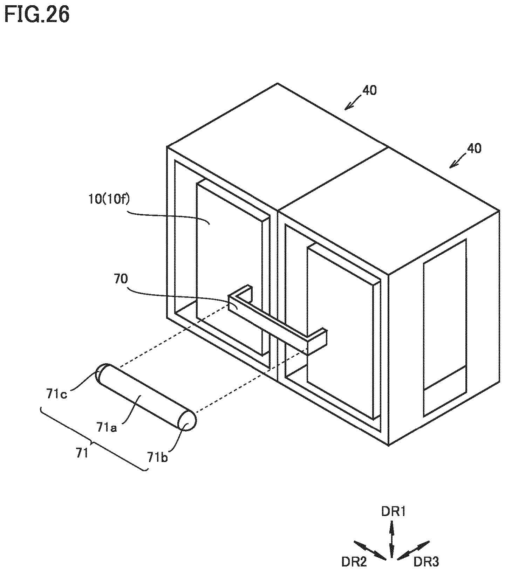

Fig. 24 is a front view of the power converter 500. Fig. 25 is a plan view of the power converter 500. Fig. 26 is an exploded perspective view of the power converter 500. Fig. 26 schematically illustrates two power conversion units 10, two insulating cases 40, and one conductive member 70. As illustrated in Figs. 24 to 26, the power converter 500 includes a plurality of power conversion units 10, a plurality of insulating structures 20 (insulating structures 20A and 20B), and a plurality of insulating posts 60. In this regard, the configuration of the power converter 500 is the same as the configuration of the power converter 400.

The power converter 500 includes a plurality of conductive members 70 and a plurality of shield members 71. Two power conversion units 10 adjacent to each other in the second direction DR2 are electrically connected by the conductive member 70. More specifically, the conductive member 70 is connected to the connection line 14a or the connection line 14b. However, in Fig. 26, the connection line 14a or the connection line 14b and the conductive member 70 are not illustrated. The conductive member 70 is attached to a front surface 10f of the power conversion unit 10. The conductive member 70 is attached by, for example, a bolt or an adhesive.

The conductive member 70 is formed of an electrically conductive material. The conductive member 70 is formed of, for example, aluminum, copper, iron, tin, stainless steel, an alloy thereof, or another metal material. The conductive member 70 may be formed of a conductive plastic mixed with a carbon-based material (carbon, graphite, carbon nanotube, graphene, or the like), a conductive plastic mixed with a metal material (silver, nickel, copper, aluminum, tin, stainless steel, iron, or the like), a conductive plastic mixed with both a carbon-based material and a metal material, or the like.

The conductive member 70 includes a first portion 70a, a second portion 70b, and a third portion 70c. The first portion 70a is connected to one power conversion unit 10, and the second portion 70b is connected to another power conversion unit 10 adjacent to the one power conversion unit 10 in the second direction DR2. The first portion 70a and the second portion 70b extend along the third direction DR3. The third portion 70c is connected to an end of the first portion 70a on the opposite side of the power conversion unit 10 and an end of the second portion 70b on the opposite side of the power conversion unit 10. The third portion 70c extends along the second direction DR2.

The conductive member 70 is formed, for example, by bending a plate material so that it can stand on its own without coming into contact with any component of the power converter 500 or any peripheral structure. However, the conductive member 70 is not limited thereto. The conductive member 70 may be, for example, a braided wire.

The shield member 71 is formed of an electrically conductive material. The shield member 71 includes, for example, a cylindrical portion 71a, a hemispherical portion 71b, and a hemispherical portion 71c. The cylindrical portion 71a has a cylindrical shape extending along the second direction DR2. The hemispherical portion 71b and the hemispherical portion 71c each have a hemispherical shape and are connected to both ends of the cylindrical portion 71a in the second direction DR2. The diameter of the hemispherical portion 71b and the hemispherical portion 71c is larger than the width of the conductive member 70. The shield member 71 covers a corner portion of the conductive member 70. More specifically, a corner portion between the first portion 70a and the third portion 70c is covered by the hemispherical portion 71b, and a corner portion between the second portion 70b and the third portion 70c is covered by the hemispherical portion 71c. In these regards, the configuration of the power converter 500 is different from the configuration of the power converter 400.

### (Effects of Power Converter 500)

The effects of the power converter 500 will be described below.

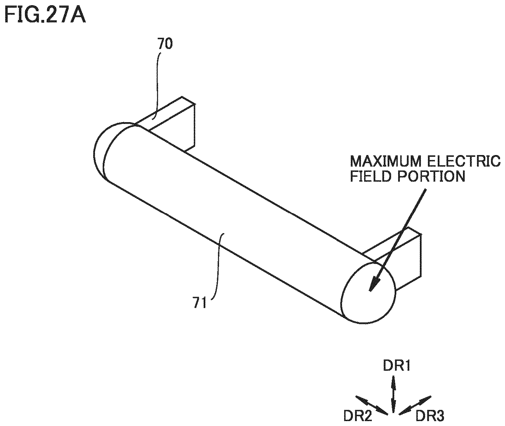

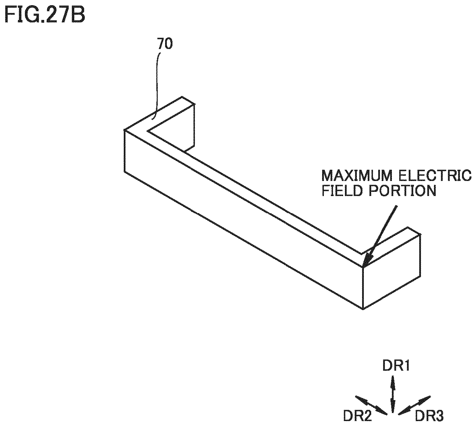

Since the conductive member 70 protrudes outside from the power converter 500, the electric field concentration is likely to occur at a corner portion of the conductive member 70 when a voltage is applied to the power conversion unit 10. In the power converter 500, since the corner portion of the conductive member 70 is covered by the shield member 71, the electric field concentration at the corner portion of the conductive member 70 can be mitigated. Fig. 27A is a perspective view illustrating the position of a maximum electric field portion in the conductive member 70 when the shield member 71 is provided. Fig. 27B is a perspective view illustrating the position of a maximum electric field portion in the conductive member 70 when the shield member 71 is not provided. In Figs. 27A and 27B, the position of the maximum electric field portion in the conductive member 70 is indicated by an arrow. As an example, in the power converter 500, the strength of the electric field in the maximum electric field portion in the conductive member 70 can be reduced to about one third of that in the case where the shield member 71 is not provided.

### Sixth Embodiment

A power converter according to a sixth embodiment will be described. The power converter according to the sixth embodiment is referred to as a power converter 600. In the present embodiment, the differences from the power converter 400 will be mainly described, and the description of the same components will not be repeated.

### (Configuration of Power Converter 600)

Hereinafter, the configuration of the power converter 600 will be described.

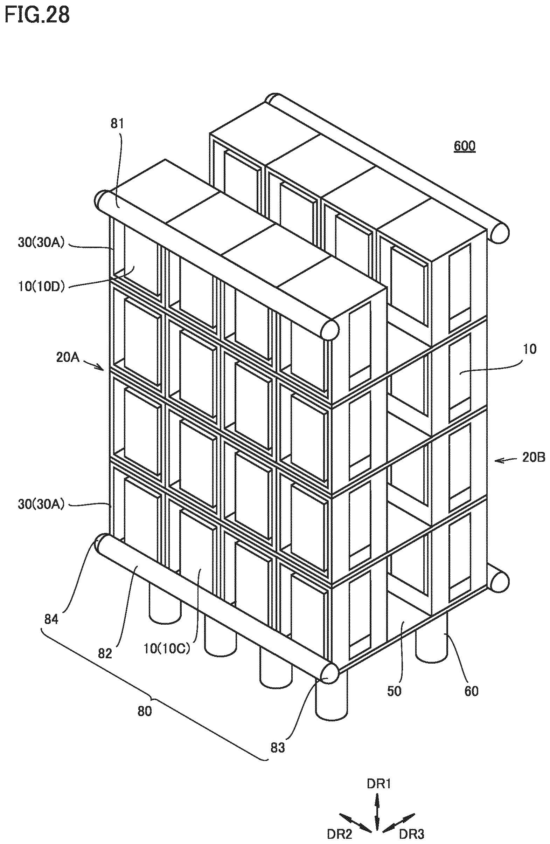

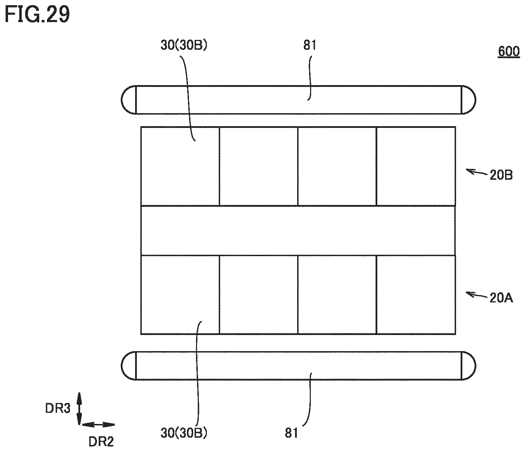

Fig. 28 is a perspective view of the power converter 600. Fig. 29 is a plan view of the power converter 600. As illustrated in Figs. 28 and 29, the power converter 600 includes a plurality of power conversion units 10, a plurality of insulating structures 20 (insulating structures 20A and 20B), and a plurality of insulating posts 60. In this regard, the configuration of the power converter 600 is the same as the configuration of the power converter 400.

The power converter 600 includes a plurality of shield members 80 and a plurality of shield members 81. Among the plurality of stacked structures 30 constituting the insulating structure 20, a stacked structure that is closest to the insulating post 60 is referred to as a stacked structure 30A. Among the plurality of stacked structures 30 constituting the insulating structure 20, a stacked structure that is farthest away from the insulating post 60 is referred to as a stacked structure 30B. The power conversion unit 10 disposed inside the stacked structure 30A is referred to as a power conversion unit 10C. The power conversion unit 10 disposed inside the stacked structure 30B is referred to as a power conversion unit 10D.

The shield member 80 extends along the second direction DR2 so as to cover a corner portion between the bottom surface 10a and the front surface 10f of the power conversion unit 10C. The shield member 81 extends along the second direction DR2 so as to cover a corner portion between the upper surface 10b and the front surface 10f of the power conversion unit 10D. In other words, the shield member 80 and the shield member 81 cover a corner portion of the power conversion unit 10 facing the ground surface. The shield member 80 and the shield member 81 have the same potential as any of the power conversion units 10. The connection between the shield member 80 and the power conversion unit 10 is not illustrated.

Each of the shield member 80 and the shield member 81 includes a cylindrical portion 82 having a cylindrical shape and extending along the second direction DR2, and a hemispherical portion 83 and a hemispherical portion 84 that are connected to both ends of the cylindrical portion 82. However, the shape of the shield member 80 or the shield member 81 is not limited thereto. Each of the shield member 80 and the shield member 81 may be, for example, a plate having rounded ends.

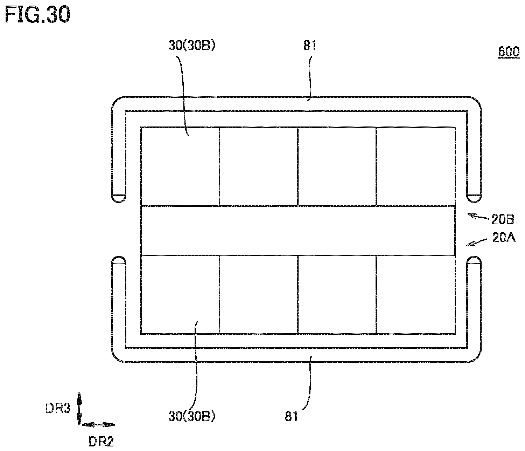

Fig. 30 is a plan view of a power converter 600 according to a modification. As illustrated in Fig. 30, both end portions of the shield member 81 may be bent along a corner portion between the upper surface 10b and the side surface 10c and a corner portion between the upper surface 10b and the side surface 10d in the power conversion unit 10D in order to protect the corner portions of the power conversion unit 10D. Although not illustrated, both end portions of the shield member 80 may also be bent along a corner portion between the bottom surface 10a and the side surface 10c and a corner portion between the bottom surface 10a and the side surface 10d in the power conversion unit 10C in order to protect the corner portions of the power conversion unit 10C.

The shield member 80 and the shield member 81 are formed of an electrically conductive material. The shield member 80 and the shield member 81 are formed of, for example, aluminum, copper, iron, tin, stainless steel, alloys thereof, or other metal materials. The shield member 80 and the shield member 81 may be formed of a conductive plastic mixed with a carbon-based material (carbon, graphite, carbon nanotube, graphene, or the like), a conductive plastic mixed with a metal material (silver, nickel, copper, aluminum, tin, stainless steel, iron, or the like), a conductive plastic mixed with both a carbon-based material and a metal material, or the like. In these regards, the configuration of the power converter 600 is different from the configuration of the power converter 500.

### (Effects of Power Converter 600)

The effects of the power converter 600 will be described below.

When a surge voltage is applied due to a failure during operation, an operation of a peripheral device, a lightning strike or the like, an electric discharge may occur from a corner portion of the power conversion unit 10C or a corner portion of the power conversion unit 10D toward a ground object. In the power converter 600, since the corner portions of the power conversion unit 10C and the power conversion unit 10D are covered by the shield member 80 and the shield member 81, the electric field concentration at the corner portions is mitigated, which makes it possible to suppress the occurrence of electric discharge as described above.

It should be understood that the embodiments disclosed herein are illustrative and non-restrictive in all respects. The basic scope of the present disclosure is defined not by the embodiments above but by the claims, and is intended to include all modifications within the scope and meaning equivalent to the claims.

### REFERENCE SIGNS LIST

10, 10A, 10B, 10C, 10D: power conversion unit; 10a: bottom surface; 10b: upper surface; 10c, 10d: side surface; 10e: back surface; 10f: front surface; 11a, 11b: switching element; 12a, 12b: diode; 13: capacitor; 14a, 14b: connection line; 20, 20A, 20B: insulating structure; 30, 30A, 30B: stacked structure; 31: bottom wall; 32: upper wall; 33: side wall; 33a: first portion; 33b: second portion; 34: side wall; 34a: first portion; 34b: second portion; 35: back wall; 36: partition wall; 36a: first portion; 36b: second portion; 40: insulating case; 41: bottom wall; 42: upper wall; 43: side wall; 43a: first portion; 43b: second portion; 44: side wall; 44a: first portion; 44b: second portion; 45: back wall; 50: insulating connection member; 60: insulating post; 70: conductive member; 70a: first portion; 70b: second portion; 70c: third portion; 71: shield member; 71a: cylindrical portion; 71b, 71c: hemispherical portion; 80, 81: shield member; 82: cylindrical portion; 83, 84: hemispherical portion; 100, 200, 300, 400, 500, 600: power converter; 100A: power converter; 110: upper arm; 120: lower arm; 130: transformer; DR1: first direction; DR2: second direction; DR3: third direction.

## Claims

1. A power converter comprising:
at least one insulating structure; and
a plurality of power conversion units,
wherein the at least one insulating structure includes a plurality of stacked structures stacked along a first direction,
each of the plurality of stacked structures has a first bottom wall, a first upper wall, a first side wall, a second side wall, and a first back wall,
the first bottom wall and the first upper wall face each other with a space therebetween in the first direction,
the first side wall and the second side wall face each other with a space therebetween in a second direction orthogonal to the first direction,
an upper end and a lower end of the first side wall are connected to one end of the first bottom wall and one end of the first upper wall in the first direction, respectively,
an upper end and a lower end of the second side wall are connected to the other end of the first bottom wall and the other end of the first upper wall in the first direction, respectively,
the first back wall is connected to one end of the first bottom wall, one end of the first side wall, and one end of the second side wall in a third direction orthogonal to the first direction and the second direction,
the first side wall and the second side wall are divided into a plurality of portions arranged with a space therebetween in the third direction,
the plurality of power conversion units are arranged in the first direction with a space therebetween in each of the plurality of stacked structures,
each of the plurality of power conversion units has a bottom surface, an upper surface, a first side surface, a second side surface, and a back surface,
the bottom surface is in contact with the first bottom wall,
the upper surface is separated from the first upper wall,
the first side surface and the second side surface face one side in the second direction and the other side in the second direction, respectively,
the back surface faces one side in the third direction,
in a first power conversion unit of the plurality of power conversion units that is adjacent to the first side wall, a corner portion between the first side surface and the back surface is covered by a corner portion between the first side wall and the first back wall,
in a second power conversion unit of the plurality of power conversion units that is adjacent to the second side wall, a corner portion between the second side surface and the back surface is covered by a corner portion between the second side wall and the first back wall.

2. The power converter according to claim 1, wherein
in the first power conversion unit, the first side surface is separated from the first side wall in the second direction, and the back surface is separated from the first back wall in the third direction, and
in the second power conversion unit, the second side surface is separated from the second side wall in the second direction, and the back surface is separated from the first back wall in the third direction.

3. The power converter according to claim 1 or 2, further comprising:
an insulating connection member,
wherein the at least one insulating structure includes a first insulating structure and a second insulating structure,
the first insulating structure and the second insulating structure are arranged in such a manner that the first back walls face each other with a space therebetween, and
the first insulating structure and the second insulating structure are connected to each other by the insulating connecting member.

4. The power converter according to any one of claims 1 to 3, wherein
each of the plurality of stacked structures includes a plurality of insulating cases arranged along the second direction,
one of the plurality of power conversion units is disposed in a corresponding one of the plurality of insulating cases,
each of the plurality of insulating cases includes a second bottom wall constituting a part of the first bottom wall, a second upper wall constituting a part of the first upper wall, a third side wall, a fourth side wall, and a second back wall constituting a part of the first back wall,
the third side wall of one of the plurality of insulating cases at one end in the second direction constitutes the first side wall,
the fourth side wall of one of the plurality of insulating cases at the other end in the second direction constitutes the second side wall.

5. The power converter according to any one of claims 1 to 4, further comprising:
a plurality of insulating posts,
wherein the plurality of insulating posts extend along the first direction, and
each of the at least one insulating structure is disposed on the plurality of insulating posts.

6. The power converter according to any one of claims 1 to 5, further comprising:
a conductive member that electrically connects two of the plurality of power conversion units that are adjacent to each other in the second direction, and a first shield member that covers the conductive member,
wherein the first shield member includes a cylindrical portion, and a first hemisphere portion and a second hemisphere portion that are connected to both ends of the cylindrical portion, and
a diameter of the first hemispherical portion and a diameter of the second hemispherical portion are equal to or larger than a width of the conductive member.

7. The power converter according to any one of claims 1 to 5, further comprising:
a second shield member,
wherein the second shield member covers a corner portion of the plurality of power conversion units that faces a ground surface.
